# EUROPEAN PATENT APPLICATION

(11) **EP 4 412 430 A1**
(43) Date of publication of application: **07.08.2024**
(21) Application number: 24152351.3
(22) Date of filing: 17.01.2024
(51) Int. Cl.: H10K 50/85, H10K 50/858, H10K 59/121, H10K 59/80, H10K 102/00

(54) **DISPLAY PANEL AND DISPLAY APPARATUS**

(30) Priority: 31.01.2023 KR 20230012894
(71) Applicant: LG Display Co., Ltd., Seoul 07336 (KR)
(72) Inventor: MUN, ByungJune, 10845 Paju-si, Gyeonggi-do (KR); SONG, AJung, 10845 Paju-si, Gyeonggi-do (KR)
(74) Representative: Viering, Jentschura & Partner mbB Patent- und Rechtsanwälte

(57) **Abstract**

A display panel (100) is provided, which includes a first area (DA1) with a fixed viewing angle and a second area (DA2) capable of controlling the viewing angle and may improve a light emission area of the first area (DA1) and lifespan. The display panel (100) may comprise a display area (DA) divided into a first area (DA1) in which a first type subpixel (SP11) is disposed and a second area (DA2) in which a second type subpixel (SP21) is disposed, wherein each of the first type subpixel (SP11) and the second type subpixel (SP21) may include a first light-emitting element (EL1, EL11, EL21) driven through a first emission control transistor (ET1) and a second light-emitting element (EL2, EL12, EL22) driven through a second emission control transistor (ET2), and the first and second light-emitting elements (EL1, EL11, EL21) of the first type subpixel (SP11) share an anode electrode (AE1).

## Description

### CROSS-REFERENCE TO RELATED APPLICATIONS

This application claims the benefit of the Korean Patent Application No. 10-2023-0012894 filed on January 31, 2023.

### BACKGROUND

### Field of the Invention

The present disclosure relates to a display panel and a display apparatus, in which a viewing angle may be controlled.

### Description of the Related Art

Electronic devices in various fields include display apparatuses that display images. For example, a plurality of display apparatuses for providing desired information or content to a driver and a passenger may be applied to a vehicle.

Among the display apparatuses mounted on a vehicle, the display apparatus disposed at the center of a dashboard is expanding in size. This display apparatus needs to selectively provide information or content to the driver and/or passenger in accordance with a driving situation of the vehicle. To this end, the display apparatus needs to control a viewing angle.

The above-described background is part of the present disclosure to devise the present disclosure or is technical information acquired by a process of devising the present disclosure, but may not be regarded as the known art disclosed to the general public before the present disclosure is disclosed.

### SUMMARY

Accordingly, the present disclosure is directed to providing a display panel and a display apparatus that substantially obviate one or more problems due to limitations and disadvantages of the related art.

An aspect of the present disclosure provides a display panel and a display apparatus, which includes a first area with a fixed viewing angle and a second area capable of controlling the viewing angle, and may improve a light emission area of the first area and lifespan.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these and other advantages and in accordance with the purpose of the disclosure, as embodied and broadly described herein, there is provided a display panel according to claim 1. Further embodiments are described in the dependent claims. In accordance with an aspect of the present disclosure, there is provided a display panel comprising a display area divided into a first area in which a first type subpixel is disposed and a second area in which a second type subpixel is disposed, wherein each of the first type subpixel and the second type subpixel may include a first light-emitting element driven through a first emission control transistor and a second light-emitting element driven through a second emission control transistor, and the first and second light-emitting elements of the first type subpixel share an anode electrode.

In accordance with another aspect of the present disclosure, there is provided a display apparatus comprising a display panel including a display area divided into a first area in which a first type subpixel is disposed and a second area in which a second type subpixel is disposed, and a gate driver disposed in a bezel area outside the display area in the display panel to drive gate lines connected to the first type subpixel and the second type subpixel, wherein each of the first type subpixel and the second type subpixel may include a first light-emitting element driven through a first emission control transistor and a second light-emitting element driven through a second emission control transistor, the first and second light-emitting elements of the first type subpixel share an anode electrode, and the gate driver may include an emission control driver controlling the first and second emission control transistors.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a schematic view illustrating a configuration of a display apparatus according to one embodiment;
FIG. 2 is an exemplary view illustrating a configuration of subpixels of first and second areas in a display panel according to one embodiment;
FIG. 3 is an exemplary view illustrating a structure that a display apparatus according to one embodiment is applied to a vehicle;
FIG. 4 is an exemplary view illustrating images of first and second areas in a display panel according to one embodiment;
FIG. 5 is an exemplary plan view illustrating a pixel structure of first and second areas in a display panel according to one embodiment;
FIGS. 6A and 6B are exemplary perspective views illustrating a structure of first and second lenses of a display panel according to one embodiment;
FIG. 7 is a cross-sectional view illustrating a (1-1)th subpixel taken along line I-I' shown in FIG. 5;
FIG. 8 is a cross-sectional view illustrating a (2-1)th subpixel taken along line II-II' shown in FIG. 5;
FIG. 9 is a schematic cross-sectional view illustrating a (1-1)th light-emitting element and a first lens area, which are taken along line III-III' shown in FIG. 5;
FIG. 10 is a schematic cross-sectional view illustrating a (1-2)th light-emitting element and a first lens area, which are taken along line IV-IV' shown in FIG. 5;
FIG. 11 is a schematic cross-sectional view illustrating a (2-2)th light-emitting element and a second lens area, which are taken along line V-V' shown in FIG. 5;
FIG. 12 is an exemplary view illustrating a method for controlling a viewing angle of a display panel according to one embodiment;
FIG. 13 is an exemplary view illustrating a method for controlling a viewing angle of a display panel according to one embodiment;
FIG. 14 is an equivalent circuit view illustrating a configuration of first and second subpixels in a display panel according to one embodiment;
FIG. 15 is an exemplary view illustrating driving waveforms of first and second subpixels in a display panel according to one embodiment; and
FIG. 16 is a graph illustrating a lifespan improvement effect of a display apparatus according to one embodiment.

### DETAILED DESCRIPTION OF THE DISCLOSURE

Advantages and features of the present disclosure, and implementation methods thereof will be clarified through following aspects described with reference to the accompanying drawings. The present disclosure may, however, be embodied in different forms and should not be construed as limited to the aspects set forth herein. Rather, these aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing aspects of the present disclosure are merely an example, and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless 'only' is used. The terms of a singular form may include plural forms unless referred to the contrary.

In construing an element, the element is construed as including an error range although there is no explicit description.

In describing a position relationship, for example, when a position relation between two parts is described as "on, " "over, " "under, " and "next, " one or more other parts may be disposed between the two parts unless a more limiting term, such as "just" or "direct (ly) " is used.

In describing a time relationship, for example, when the temporal order is described as, for example, "after, " "subsequent, " "next, " and "before, " a case which is not continuous may be included unless a more limiting term, such as "just, " "immediate (ly), " or "direct (ly) " is used.

It will be understood that, although the terms "first, " "second, " etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing the elements of the present disclosure, the terms "first, " "second, " "A, " "B, " " (a), " " (b), " etc., may be used. These terms are intended to identify the corresponding elements from the other elements, and basis, order, or number of the corresponding elements should not be limited by these terms. As for the expression that an element or a layer is "connected, " "coupled, " or "adhered" to another element or layer, the element or layer may not only be directly connected or adhered to another element or layer, but also be indirectly connected or adhered to another element or layer with one or more intervening elements or layers "disposed" between the elements or layers, unless otherwise specified.

The term "at least one" should be understood as including any and all combinations of one or more among the associated listed elements. For example, the meaning of "at least one or more of a first element, a second element, and a third element" denotes the combination of all elements proposed from two or more of the first element, the second element, and the third element as well as the first element, the second element, or the third element.

Features of various aspects of the present disclosure may be partially or overall coupled to or combined with each other, and may be variously inter-operated with each other and driven technically as those skilled in the art may sufficiently understand. The aspects of the present disclosure may be carried out independently from each other, or may be carried out together in codependent relationship.

Hereinafter, the aspect of the present disclosure will be described with reference to the accompanying drawings. Since a scale of each of elements shown in the accompanying drawings is different from an actual scale for convenience of description, the present disclosure is not limited to the shown scale. Further, all the components of each display apparatus according to all aspects of the present disclosure are operatively coupled and configured.

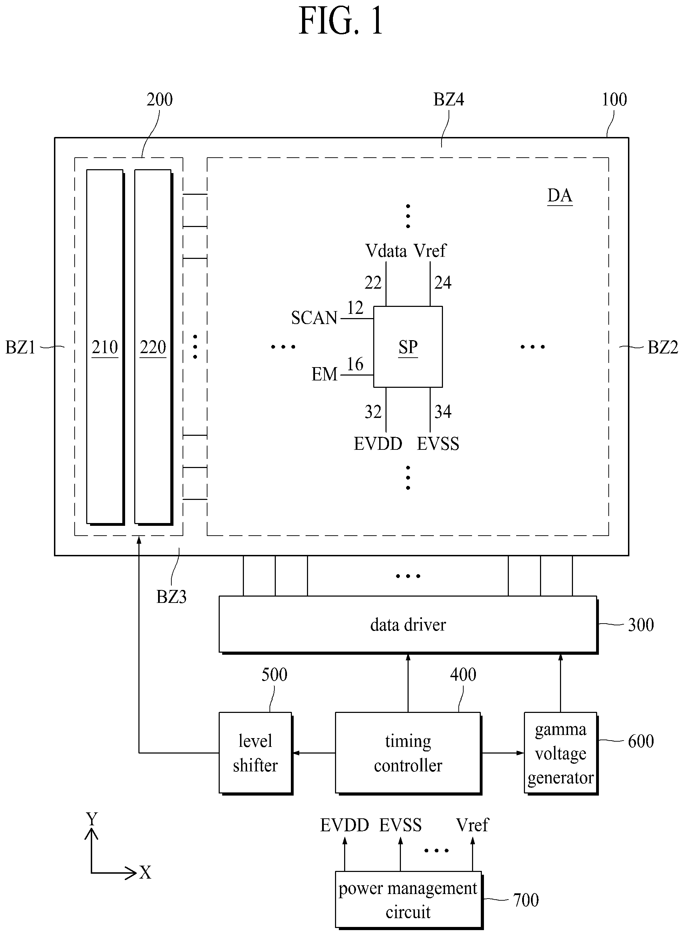

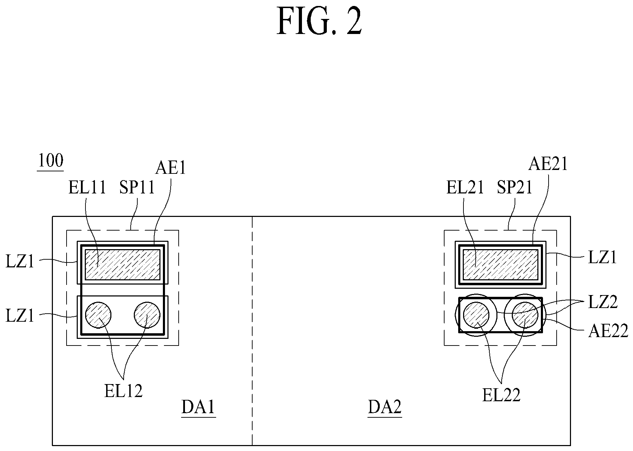

FIG. 1 is a schematic view illustrating a configuration of a display apparatus according to one embodiment, and FIG. 2 is an exemplary view illustrating a configuration of subpixels of first and second areas in a display panel according to one embodiment.

The display apparatus according to one embodiment may be an electroluminescent display apparatus that includes an organic light-emitting diode (OLED) display apparatus, a quantum-dot light-emitting diode display apparatus or an inorganic light-emitting diode display apparatus.

Referring to FIG. 1, the display apparatus according to one embodiment includes a display panel 100, a gate driver 200 embedded in the display panel 100, a data driver 300 connected to the display panel 100, a timing controller 400 controlling the gate driver 200 and the data driver 300, a gamma voltage generator 600, and a power management circuit 700. In one embodiment, the display apparatus may further include a level shifter 500 connected between the timing controller 400 and the gate driver 200. In one embodiment, the data driver 300, the timing controller 400, the gamma voltage generator 600 and the level shifter 500 may be integrated into a display driver.

The display panel 100 may be a rigid display panel, or may be a flexible display panel, of which shape may be modified, such as a foldable, bendable, rollable or stretchable display panel.

The display panel 100 may include a display area DA for displaying an image, and bezel areas BZ1 to BZ4 surrounding the display area DA, positioned at an outer portion.

The display panel 100 may display an image by using the display area DA in which the plurality of subpixels SP are arranged in a matrix form. A pixel matrix disposed in the display area DA may include a plurality of row lines including a plurality of subpixels SP arranged in a first direction X and a plurality of column lines including a plurality of subpixels arranged in a second direction Y.

Each subpixel SP may be any one of a red subpixel for emitting red light, a green subpixel for emitting green light, a blue subpixel for emitting blue light and a white subpixel for emitting white light. A unit pixel may include at least two subpixels.

A plurality of signal lines, which include a data line 22, gate lines 12 and 16 and power lines 24, 32 and 34, which are connected to each subpixel SP, may be disposed in the display panel 100.

The data line 22 may supply a data voltage Vdata supplied from the data driver 300 to each subpixel SP.

At least one gate line 12 of the gate lines 12 and 16 may supply a scan signal SCAN supplied from the gate driver 200 to each subpixel SP, and at least one gate line 16 may supply an emission control signal EM supplied from the gate driver 12 to each subpixel SP.

Among the power lines 24, 32 and 34, an initialization voltage line 24 may supply an initialization voltage Vref supplied from the power management circuit 700 to each subpixel SP, and a first power line 32 may supply a first power voltage (high potential power voltage) EVDD to each subpixel SP, and a second power line 34 may supply a second power voltage (low potential power voltage) EVSS to each subpixel SP through a common electrode (cathode electrode).

Referring to FIG. 2, the display area DA of the display panel 100 according to one embodiment may be divided into a first area DA1 for displaying an image in a wide viewing angle mode, and a second area DA2 capable of switching a wide viewing angle mode and a narrow viewing angle mode to and from each other. The wide viewing angle mode may be expressed as a share mode. The narrow viewing angle mode narrower than the wide viewing angle mode may be expressed in a privacy mode. The second area DA2 may be expressed as a switchable privacy mode capable of switching the share mode and the privacy mode to and from each other.

A first type subpixel SP11 disposed in the first area DA1 may include a first light-emitting element EL11 and a second light-emitting element EL12, which share an anode electrode AE1, and a pixel circuit including a plurality of transistors for respectively driving the first and second light-emitting elements EL11 and EL12, and a first lens area LZ1 disposed on each of the first and second light-emitting elements EL11 and EL12.

A second type subpixel SP21 disposed in the second area DA2 may include a first light-emitting element EL21 having a first anode electrode AE21, a second light-emitting element EL22 having a second anode electrode AE22, a pixel circuit including a plurality of transistors for respectively driving the first and second light-emitting elements EL21 and EL22, a first lens area LZ1 disposed on the first light-emitting element EL21, and a second lens area LZ2 disposed on the second light-emitting element EL22.

In the first type subpixel SP11 of the first area DA1, the first and second light-emitting elements EL11 and EL12 may share the anode electrode AE1 to simultaneously emit light, thereby implementing the wide viewing angle mode or the share mode through the first lens area LZ1. This will be described later in detail.

The second type subpixel SP21 of the second area DA2 may implement the wide viewing angle mode or the share mode through the first lens area LZ1 when the first light-emitting element EL21 is driven. The second type subpixel SP21 of the second area DA2 may implement the narrow viewing angle mode or the privacy mode for limiting the viewing angle through the second lens area LZ2 when the second light-emitting element EL21 is driven. This will be described later in detail.

The display panel 100 according to one embodiment may further include a touch sensor screen disposed in the display area DA to sense a user's touch.

The display panel 100 according to one embodiment may be a touch display panel in which a touch sensor array is embedded. According to one embodiment of the present disclosure, the display panel 100 may include a pixel array including a circuit element layer having a plurality of transistors disposed on a substrate and a light-emitting element layer including a plurality of light-emitting elements disposed on the circuit element layer, an encapsulation layer disposed on the pixel array to seal the light-emitting element layer, a touch sensor array including a plurality of touch electrodes disposed on the encapsulation layer, and a lens array including first and second lenses disposed on the touch sensor array. The display panel 100 according to one embodiment may further include an optical film, an optical clear adhesive (OCA), a cover substrate and a protective film, which are sequentially disposed on the lens array. The display panel 100 according to one embodiment may further include a color filter array including a color filter and a black matrix, which are disposed between the touch sensor array and the lens array.

The gate driver 200 may be disposed in at least one of the plurality of bezel areas BZ1 and BZ2 positioned at the outer portion of the display area DA. For example, the gate driver 200 may be disposed in any one of the first and second bezel areas BZ1 and BZ2 facing each other with the display area DA interposed therebetween or may be disposed at both sides of the first and second bezel areas BZ1 and BZ2. The gate driver 200 may be disposed in a gate-in-panel (GIP) type including transistors formed in the same process as that of the transistors disposed in the display area DA.

The gate driver 200 may include a scan driver 210 for driving at least one gate line 12 of the plurality of gate lines 12 and 16 connected to the subpixels SP of each pixel row line, and an emission control driver 220 for driving at least one gate line 16.

The number of the gate lines 12 and 16, the number of scan drivers 210 and the number of emission control drivers 220, which are connected to the subpixels SP of each pixel row line, are not limited to those illustrated in FIG. 1, and may be variously changed depending on a detailed configuration of the pixel circuit constituting each subpixel SP.

Each of the scan driver 210 and the emission control driver 220 may operate by receiving the plurality of gate control signals supplied from the timing controller 400 through the level shifter 500. In one embodiment, each of the scan driver 210 and the emission control driver 220 may be supplied with the plurality of gate control signals from the timing controller 400.

The level shifter 500 may receive control signals from the timing controller 400 and perform level shifting or logic processing for the received control signals to generate a plurality of gate control signals and supply the gate control signals to the scan driver 210 and the emission control driver 220.

The scan driver 210 may supply at least one scan signal SCAN to each of the plurality of pixel row lines by using the plurality of gate control signals supplied from the level shifter 500 or the timing controller 400. The scan driver 210 may supply the scan signal SCAN to at least one gate line 12 of the plurality of gate lines 12 and 16 connected to the subpixels SP of each pixel row line.

The emission control driver 220 may supply the plurality of emission control signals to each of the plurality of pixel lines by using the plurality of gate control signals supplied from the level shifter 500 or the timing controller 400. The emission control driver 220 may supply the emission control signal EM to at least one gate line 16 of the plurality of gate lines 12 and 16 connected to the subpixels SP of each pixel row line.

The emission control driver 220 according to one embodiment may supply the plurality of emission control signals to each subpixel SP. The emission control driver 220 may control simultaneous driving of the first and second light-emitting elements EL11 and EL 12 in the first type subpixel 11 of the first area DA1 by using the plurality of emission control signals, and may selectively control driving of the first light-emitting element EL21 and the second light-emitting element EL22 in the second type subpixel SP21 of the second area DA2. This will be described later in detail.

At least one of a low temperature poly silicon (LTPS) transistor using an LTPS semiconductor or an oxide transistor using a metal-oxide semiconductor may be applied to the plurality of transistors disposed in the display area DA of the display panel 100 and the bezel areas BZ1 to BZ4 including the gate driver 200. The display panel 100 according to one embodiment may be configured such that the LTPS transistor and the oxide transistor coexist in order to reduce power consumption.

The gamma voltage generator 600 may generate a plurality of reference gamma voltages having different voltage levels and supply the reference gamma voltages to the data driver 300. The gamma voltage generator 600 may generate the plurality of reference gamma voltages corresponding to gamma characteristics of the display apparatus under the control of the timing controller 400 and supply the reference gamma voltages to the data driver 300. In one embodiment, the gamma voltage generator 600 may adjust reference gamma voltage levels in accordance with gamma data supplied from the timing controller 400 and output the reference gamma voltage levels to the data driver 300.

The data driver 300 may supply each data voltage Vdata to each data line 22 of the display panel 100 by converting digital data supplied from the timing controller 400 together with the data control signals into an analog data signal. The data driver 300 may subdivide the plurality of reference gamma voltages supplied from the gamma voltage generator 600 and convert the digital data into an analog data voltage by using the subdivided gamma voltages.

The data driver 300 may include at least one data drive integrated circuit (IC) for driving the plurality of data lines DL disposed in the display panel 100. Each data drive IC may be packaged on each circuit film and connected to the display panel 100. The circuit film in which the data drive IC is packaged may be bonded and connected to a bezel area BZ3, in which a pad area of the display panel 100 is disposed, through an anisotropic conductive film (ACF). A chip on film (COF), a flexible printed circuit (FPC) or a flexible flat cable (FFC) may be used in the circuit film.

The timing controller 400 may control the gate driver 200 and the data driver 300 by using timing control signals supplied from a host system and timing setting information stored therein.

The timing controller 400 according to one embodiment may generate the plurality of gate control signals for controlling the driving timing of the gate driver 200 and supply the generated gate control signals to the gate driver 200. The timing controller 400 according to one embodiment may generate control signals for timing control and supply the control signals to the level shifter 500 so that the level shifter 500 may generate the plurality of gate control signals and supply the gate control signals to the gate driver 200.

The timing controller 400 may generate the plurality of data control signals for controlling the driving timing of the data driver 300 and supply the generated data control signals to the data driver 300. The timing controller 400 according to one embodiment may perform various kinds of image processing including image quality correction, deterioration correction and luminance correction for decrease of power consumption by receiving input image data, and supply the image-processed data to the data driver 300.

The power management circuit 700 may generate and supply a plurality of driving voltages required for the operation of all circuit elements of the display apparatus by using an input voltage. The power management circuit 700 may generate a first power voltage EVDD, a second power voltage EVSS and an initialization voltage Vref (reference voltage) to supply them to the display panel 100. The power management circuit 700 may generate and supply various driving voltages required for the operation of the gate driver 200, the data driver 300, the timing controller 400, the level shifter 500 and the gamma voltage generator 600.

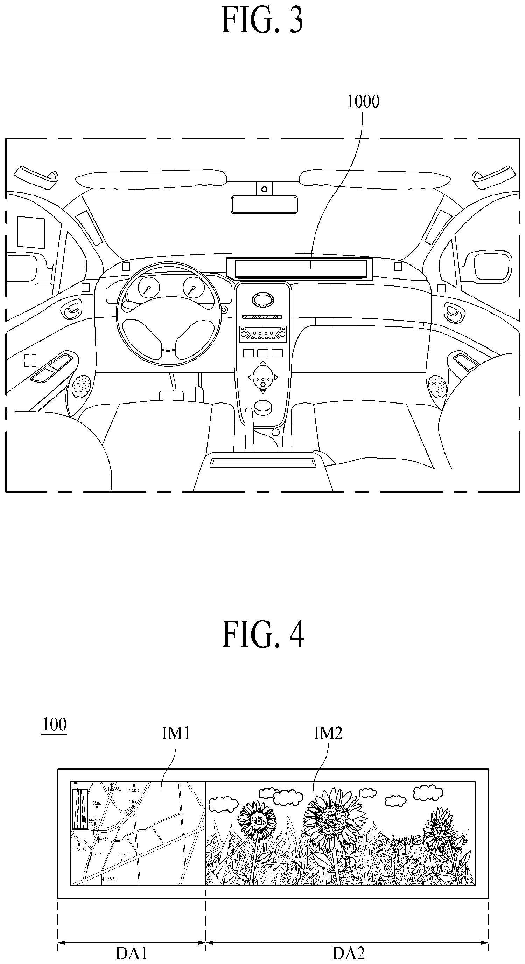

FIG. 3 is an exemplary view illustrating a structure that a display apparatus according to one embodiment is applied to a vehicle, and FIG. 4 is an exemplary view illustrating images of first and second areas in a display panel according to one embodiment.

Referring to FIGS. 3 and 4, a display apparatus 1000 according to one embodiment may be disposed at the center of a dashboard of a vehicle to provide an image to both a driver and a passenger of a passenger seat. The display panel 100 of the display apparatus 1000 may include a first area DA1 and a second area DA2.

In one embodiment, the first area DA1 of the display panel 100 may be expressed as a Center Information Display (CID) area or a share mode area, and the second area DA2 may be expressed as a co-driver display (CDD) area or a switchable privacy mode area.

Referring to FIGS. 2 and 4, the first area DA1 of the display panel 100 may include first type subpixels SP11, and the second area DA2 may include second type subpixels SP21.

In the first type subpixels SP11 of the first area DA1 of the display panel 100, the first and second light-emitting elements EL11 and EL12 sharing the anode electrode AE1 may simultaneously emit light to implement the wide viewing angle mode or the share mode through the first lens area LZ1.

Therefore, the first area DA1 of the display panel 100 may provide a first image IM1 having a wide viewing angle in a left-right direction to a driver and a passenger of a passenger seat.

In the second area DA2 of the display panel 100, the second type subpixels SP21 may implement the wide viewing angle mode or the share mode through the first lens area LZ1 when the first light-emitting element EL21 is driven, and may implement the narrow viewing angle mode or the privacy mode for limiting a viewing angle through the second lens area LZ2 when the second light-emitting element EL22 is driven.

Therefore, the second area DA2 of the display panel 100 may provide, to the passenger, a second image IM2 having a narrow viewing angle in the left-right direction so as not to disturb the driver's driving. In one embodiment, when the driver does not drive, the second area DA2 of the display panel 100 may provide the driver and the passenger with the second image IM2 having a wide viewing angle in the left-right direction in accordance with the user 's request or content.

The display apparatus 1000 according to one embodiment is not limited to a display apparatus for a vehicle, and may be applied to various display apparatuses such as a mobile display, an IT display and a TV display.

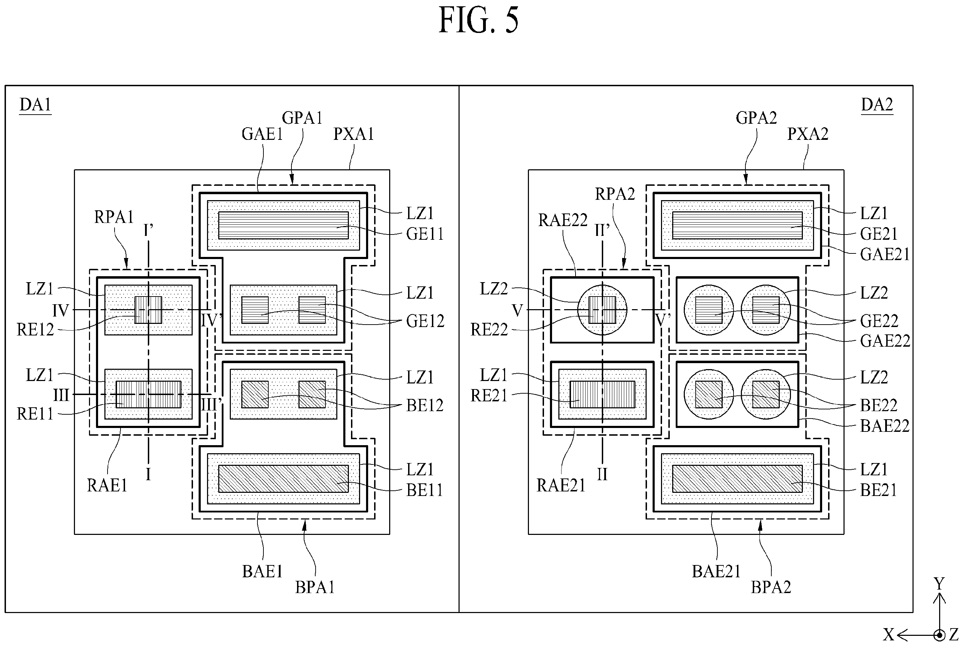

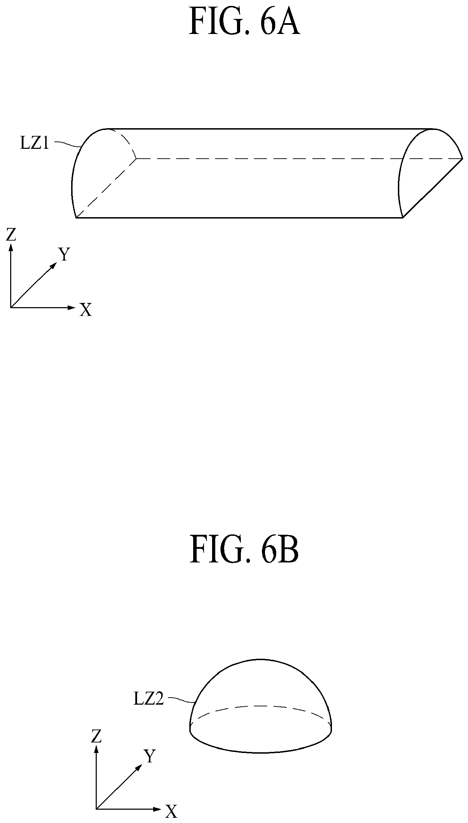

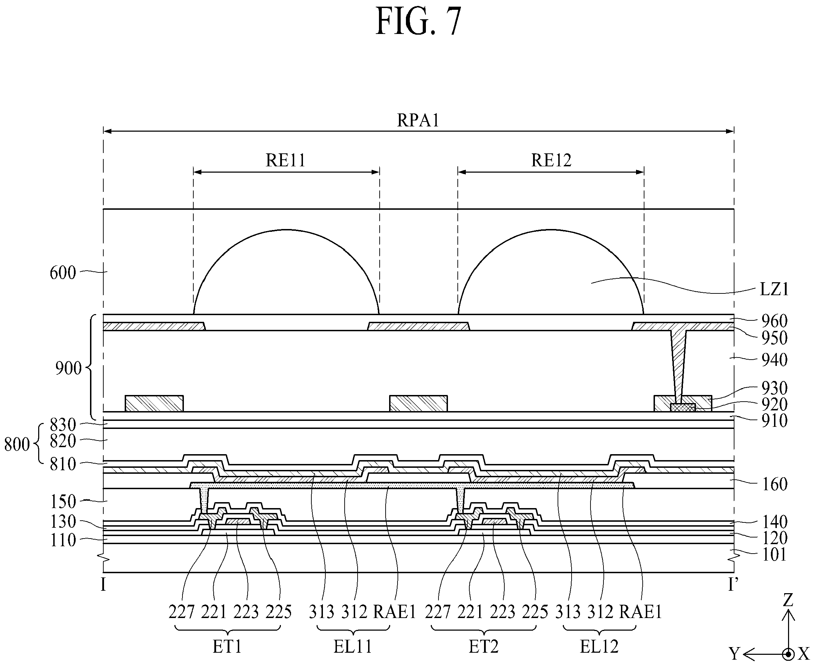

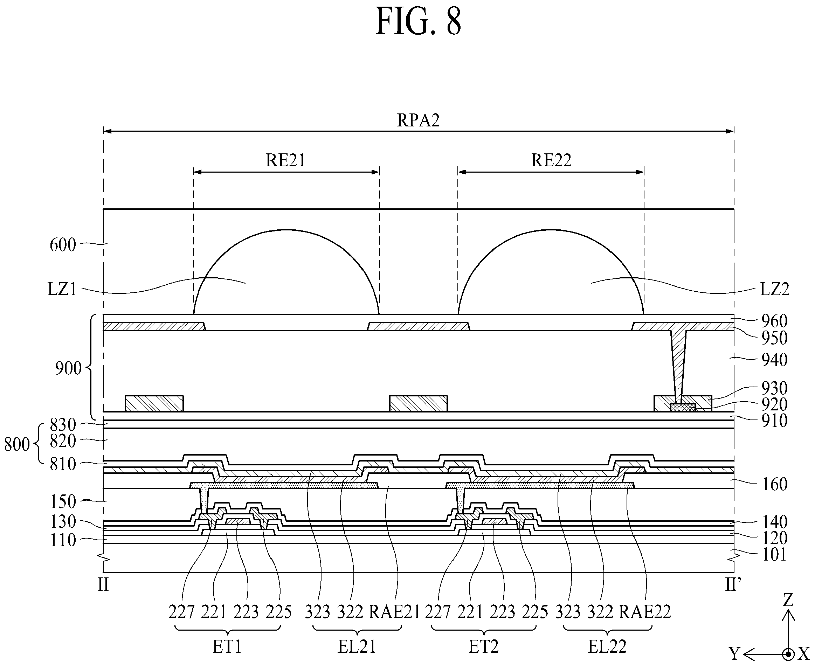

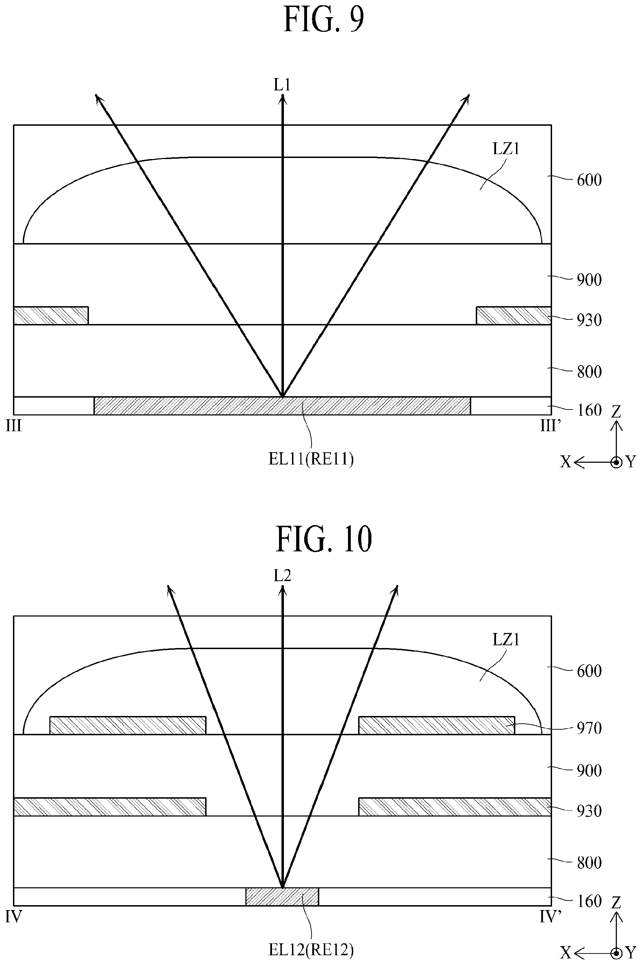

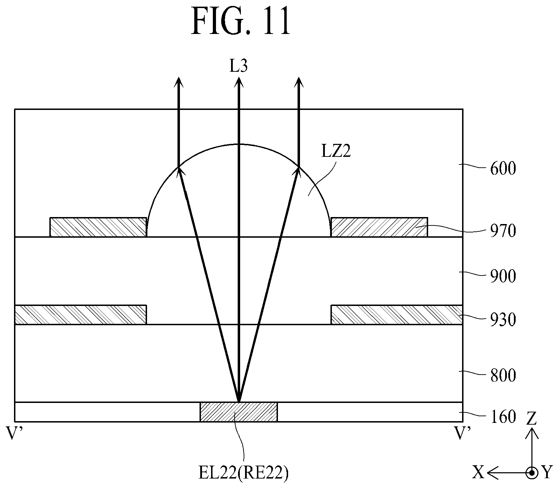

FIG. 5 is an exemplary plan view illustrating a pixel structure of first and second areas in a display panel according to one embodiment, FIGS. 6A and 6B are exemplary perspective views illustrating structures of first and second lenses of a display panel according to one embodiment. FIG. 7 is a cross-sectional view illustrating a first type subpixel taken along line I-I' shown in FIG. 5, and FIG. 8 is a cross-sectional view illustrating a second type subpixel taken along line II-II' shown in FIG. 5. FIG. 9 is a schematic cross-sectional view illustrating a (1-1)th light-emitting element and a first lens area, which are taken along line III-III' shown in FIG. 5, FIG. 10 is a schematic cross-sectional view illustrating a (1-2)th light-emitting element and a first lens area, which are taken along line IV-IV' shown in FIG. 5, and FIG. 11 is a schematic cross-sectional view illustrating a (2-2)th light-emitting element and a second lens area, which are taken along line V-V' shown in FIG. 5.

Referring to FIG. 5, the first area DA1 of the display panel according to one embodiment may include a first type pixel area PXA1 or a first type pixel, and the second area DA2 may include a second type pixel area PXA2 or a second type pixel.

The first type pixel area PXA1 disposed in the first area DA1 may include a first type red (R) subpixel area RPA1 for emitting red light, a first type green (G) subpixel area GPA1 for emitting green light, and a first type blue (B) subpixel area BPA1 for emitting blue light. The first type R, G and B subpixel areas RPA1, GPA1 and BPA1 may be expressed as a (1-1)th type subpixel, a (1-2)th type subpixel and a (1-3)th type subpixel, respectively.

The first type R subpixel area RPA1 may include a first light emission area RE11 of the first light-emitting element EL11, a first lens area LZ1 disposed on the first light emission area RE11 to overlap the first light emission area RE11, a second light emission area RE12 of the second light-emitting element EL12, and a first lens area LZ1 disposed on the second light emission area RE12 to overlap the second light emission area RE12. The light emission area RE11 of the first light-emitting element EL11 and the second light emission area RE12 of the second light-emitting element EL12 may share an anode electrode RAE1. A size of the first light emission area RE11 may be greater than that of the second light emission area RE12.

The first type G subpixel area GPA1 may include a first light emission area GE11 of the first light-emitting element, a first lens area LZ1 disposed on the first light emission area GE11 to overlap the first light emission area GE11, a plurality of second light emission areas GE12 of the second light-emitting element, and a first lens area LZ1 disposed on the second light emission area GE12 to overlap the second light emission area GE12. The first light emission area GE11 of the first light-emitting element and the second light emission area GE12 of the second light-emitting element may share an anode electrode GAE1. The first type G subpixel area GPA1 may include one first lens area LZ1 disposed on one first light emission area GE11, and may include one first lens area LZ1 disposed on the plurality of second light emission areas GE12. A size of the first light emission area GE11 may be greater than that of the plurality of second light emission areas GE12.

The first type B subpixel area BPA1 may include a first light emission area BE11 of the first light-emitting element, a first lens area LZ1 disposed on the first light emission area BE11 to overlap the first light emission area BE11, a second light emission area BE12 of the second light-emitting element, and a first lens area LZ1 disposed on the second light emission area BE12 to overlap the second light emission area BE12. The first light emission area BE11 of the first light-emitting element and the second light emission area BE12 of the second light-emitting element may share an anode electrode BAE1. The first type B subpixel area BPA1 may include one first lens area LZ1 disposed on one first light emission area BE11, and may include one first lens area LZ1 disposed on the plurality of second light emission areas BE12. A size of the first light emission area BE11 may be greater than that of the plurality of second light emission areas BE12.

The second type pixel area PXA2 disposed in the second area DA2 may include second type R, G and B subpixel areas RPA2, GPA2 and BPA2. The second type R, G and B subpixel areas RPA2, GPA2 and BPA2 may be expressed as a (2-1)th type subpixel, a (2-2)th type subpixel and a (2-3)th type subpixel, respectively.

The second type R subpixel area RPA2 may include a first light emission area RE21 of the first light-emitting element EL21, a first lens area LZ1 disposed on the first light emission area RE21 to overlap the first light emission area RE21, a second light emission area RE22 of the second light-emitting element EL22, and a second lens area LZ2 disposed on the second light emission area RE22 to overlap the second light emission area RE22. The second type R subpixel area RPA2 may include one first lens area LZ1 disposed on one first light emission area RE21, and may include one second lens area LZ2 disposed on at least one second light emission area RE22. A size of the first light emission area RE21 may be greater than that of the plurality of second light emission areas RE22.

The second type G subpixel area GPA2 may include a first light emission area GE21 of the first light-emitting element, a first lens area LZ1 disposed on the first light emission area GE21 to overlap the first light emission area GE21, a plurality of second light emission areas GE22 of the second light-emitting element, and a second lens area LZ2 disposed on the second light emission area GE22 to overlap the second light emission area GE22. The second type G subpixel area GPA2 may include one first lens area LZ1 disposed on one first light emission area GE21, and may include a plurality of second lens areas LZ2 disposed on the plurality of second light emission areas GE22. A size of the first light emission area GE21 may be greater than that of the plurality of second light emission areas GE22.

The second type B subpixel area BPA2 may include a first light emission area BE21 of the first light-emitting element, a first lens area LZ1 disposed on the first light emission area BE21 to overlap the first light emission area BE21, a plurality of second light emission areas BE22 of the second light-emitting element, and a second lens area LZ2 disposed on the second light emission area BE22 to overlap the second light emission area BE22. The second type B subpixel area BPA2 may include one first lens area LZ1 disposed on one first light emission area BE21, and may include a plurality of second lens areas LZ2 disposed on the plurality of second light emission areas BE22. A size of the first light emission area GE21 may be greater than that of the plurality of second light emission areas GE22.

Referring to FIG. 6A, the first lens area LZ1 may include a half-cylindrical lens elongated in the first direction X. Referring to FIG. 3b, the second lens area LZ2 may include a half-spherical lens.

In FIGS. 6A and 6B, the first direction X may be expressed as a left-right direction, a horizontal direction, a parallel direction or X-axis direction. The second direction Y may be expressed as an up and down direction, a vertical direction or Y-axis direction. The third direction Z may be expressed as a front-rear direction, a thickness direction of the display panel 100 or Z-axis direction.

The first lens area LZ1 and the second lens area LZ2 may differently control (limit) the viewing angle of the left-right direction X and equally control (limit) the viewing angle in the up and down direction Y.

For example, the first lens area LZ1 may control the viewing angle at a wide viewing angle as a moving path of light emitted from each of the light-emitting elements EL11, EL12 and EL21 is not be limited within a specific angle in the left-right direction X. The second lens area LZ2 may control the viewing angle at a narrow viewing angle as a moving path of light emitted from each light-emitting element EL22 is not be limited within a specific angle in the left-right direction X.

In both the first lens area LZ1 and the second lens area LZ2, the moving path of the light may be limited within a specific angle in the up and down direction Y, whereby the viewing angle may be controlled at a narrow viewing angle. Therefore, in one embodiment, when the display apparatus 1000 is applied to the vehicle as shown in FIG. 3, it is possible to prevent the driver's view from being disturbed as images displayed on the first and second areas DA1 and DA2 of the display panel 100 are reflected by a windshield of the vehicle.

The size of the first lens area LZ1 may be set to be greater than the size of each of the light emission areas RE11, GE11, BE11, RE12, GE12, BE12, RE21, GE21 and BE21, so that emission efficiency of the light generated from each of the light emission areas RE11, GE11, BE11, RE12, GE12, BE12, RE21, GE21 and BE21 may be improved.

The size of the first lens area LZ2 may be set to be greater than the size of each of the light emission areas RE22, GE22 and BE22, so that emission efficiency of the light generated from each of the light emission areas RE22, GE22 and BE22 may be improved.

In the embodiment, the second light emission areas RE12, GE12, BE12, RE22, GE22 and BE22 of the respective pixel areas PXA1 and PXA2 may have the same area, and the number of the second light emission areas RE12, GE12, BE12, RE22, GE22 and BE22 may be different for each color of the subpixel areas RPA1, RPA2, GPA1, GPA2, BPA1 and BPA2. For example, the number of the second light emission areas GE12 and GE22 of the G subpixel areas GPA1 and GPA2 and the number of the second light emission areas BE12 and BE22 of the B subpixel areas BPA1 and BPA2 may be larger than the number of the second light emission areas RE12 and RE22 of the R subpixel areas RPA1 and RPA2. The number of the second light emission areas BE12 and BE22 of the B subpixel areas BPA1 and BPA2 may be larger than the number of the second light emission areas GE12 and GE22 of the G subpixel areas GPA1 and GPA2. Therefore, an efficiency deviation of the second R, G and B light-emitting elements in the respective pixel areas PXA1 and PXA2 may be supplemented by the number of the second light emission areas RE12, GE12, BE12, RE22, GE22 and BE22.

In the embodiment, the sizes of the first light emission areas RE11, GE11, BE11, RE21, GE21 and BE21 of the respective pixel areas PXA1 and PXA2 may be different for each color. For example, the size of the first light emission areas GE11 and GE21 of the G subpixel areas GPA1 and GPA2 and the size of the first light emission areas BE11 and BE21 of the B subpixel areas BPA1 and BPA2 may be greater than the size of the first light emission areas RE11 and RE21 of the R pixel subpixel areas RPA1 and RPA2. The size of the first light emission areas BE11 and BE12 of the B subpixel areas BPA1 and BPA2 may be greater than the size of the first light emission areas GE11 and GE21 of the G subpixel areas GPA1 and GPA2. Therefore, an efficiency deviation of the first R, G and B light-emitting elements in the respective pixel areas PXA1 and PXA2 may be supplemented by the number of the first light emission areas RE11, GE11, BE11, RE21, GE21 and BE21.

As shown in FIGS. 7 and 8, the display panel 100 according to one embodiment may include a substrate 101, a circuit element layer including transistors ET1 and ET2 disposed on the substrate 101, a light-emitting element layer including light-emitting elements EL11, EL12, EL21 and EL22 disposed on the circuit element layer, an encapsulation layer 800 disposed on the light-emitting element layer, and a lens layer including lenses LZ1 and LZ2 disposed on the encapsulation layer 800. The display panel 100 according to one embodiment may further include a touch sensor layer 900 disposed between the encapsulation layer 800 and the lens layer. The display panel 100 according to one embodiment may further include a color filter layer (not shown) that includes a color filter and a black matrix, which are disposed between the touch sensor layer 900 and the lens layer.

A cross-sectional structure of the R subpixel area RPA1 of the first type R, G and B subpixel areas RPA1, GPA1 and BPA1 in the display panel according to one embodiment will be described with reference to FIG. 7. The first type R, G and B subpixel areas RPA1, GPA1 and BPA1 may have the same cross-sectional structure. A cross-sectional structure of the R subpixel area RPA2 of the second type R, G and B subpixel areas RPA2, GPA2 and BPA2 in the display panel according to one embodiment will be described with reference to FIG. 8. The second type R, G and B subpixel areas RPA2, GPA2 and BPA2 may have the same cross-sectional structure.

The first type subpixel area RPA1 of the display panel according to one embodiment may include a plurality of first lens areas LZ1 shown in FIG. 7, and the second type subpixel area RPA2 may include first and second lens areas LZ1 and LZ2 shown in FIG. 8.

Referring to FIG. 7, the first type subpixel area RPA1 may include a first emission control transistor ET1 and a second emission control transistor ET2 of a pixel circuit, a (1-1)th light-emitting element EL11 connected to the first emission control transistor ET1, a (1-2)th light-emitting element EL12 connected to the second emission control transistor ET2, a first lens area LZ1 disposed to overlap the (1-1)th light emission area RE11 on the (1-1)th light-emitting element EL11, and a first lens area LZ1 disposed to overlap the (1-2)th light emission area RE12 on the (1-2)th light-emitting element EL12.

Referring to FIG. 8, the second type subpixel area RPA2 may include a first emission control transistor ET1 and a second emission control transistor ET2 of a pixel circuit, a (2-1)th light-emitting element EL21 connected to the first emission control transistor ET1, a (2-2)th light-emitting element EL22 connected to the second emission control transistor ET2, a first lens area LZ1 disposed to overlap the (2-1)th light emission area RE21 on the (2-1)th light-emitting element EL21, and a second lens area LZ2 disposed to overlap the (2-2)th light emission area RE22 on the (2-2)th light-emitting element EL22.

The circuit element layer disposed on the substrate 101 in the display panel according to one embodiment may include a plurality of insulating layers stacked on the substrate 101. For example, the plurality of insulating layers may include a buffer layer 110, a gate insulating layer 120, an interlayer insulating layer 130, a passivation layer 140 and a planarization layer 150.

The substrate 101 may include an insulating material such as glass or plastic. The plastic substrate may be formed of a flexible material. For example, the substrate 101 may include at least one organic insulating material of an acrylic resin, an epoxy-based resin, a siloxane-based resin, a polyimide-based resin or a polyamide-based resin.

The buffer layer 110 may have a single-layered structure or a multi-layered structure, which includes an inorganic insulating material such as silicon oxide (SiOx), silicon nitride (SiNx) and aluminum oxide (Al₂O₃). The buffer layer 110 may prevent impurities such as hydrogen from flowing into semiconductor layers 211 and 221 through the substrate 101.

The transistors ET1 and ET2 may be disposed on the buffer layer 110.

According to one embodiment, the buffer layer 110 may include a multi-buffer layer and an active buffer layer. In this case, the multi-buffer layer may be disposed on the substrate 101, and the active buffer layer may be disposed on the multi-buffer layer. A light blocking layer (or a light blocking metal or BSM) may be disposed between the multi buffer layer and the active buffer layer.

The first emission control transistor ET1 includes a semiconductor layer 211, a gate electrode 213, a source electrode 215 and a drain electrode 217, which are disposed on the buffer layer 110. The second emission control transistor ET2 includes a semiconductor layer 221, a gate electrode 223, a source electrode 225 and a drain electrode 227, which are disposed on the buffer layer 110. The gate insulating layer 120 is disposed between the semiconductor layers 211 and 221 and the gate electrodes 213 and 223. The interlayer insulating layer 130 is disposed between the gate electrodes 213 and 223 and the source and drain electrodes 215, 217, 225 and 227. The source electrode 215 and the drain electrode 217 of the first emission control transistor ET1 may be connected to a source area and a drain area of the semiconductor layer 211 through each of contact holes passing through the interlayer insulating layer 130 and the gate insulating layer 120. The source electrode 225 and the drain electrode 227 of the second emission control transistor ET2 may be connected to a source area and a drain area of the semiconductor layer 221 through each of contact holes passing through the interlayer insulating layer 130 and the gate insulating layer 120.

The semiconductor layers 211 and 221 may include polycrystalline silicon, or may include an oxide semiconductor material. The semiconductor layers 211 and 221 may include low temperature polysilicon (LTPS). The semiconductor layers 211 and 221 may include at least one of IZO(InZnO)-based, IGO(InGaO)-based, ITO(InSnO)-based, IGZO(InGaZnO)-based, IGZTO(InGaZnSnO)-based, GZTO(GaZnSnO)-based, GZO(GaZnO)-based or ITZO(InSnZnO)-based oxide semiconductor material. The light blocking layer (not shown) may be further disposed below the semiconductor layers 211 and 221.

The gate insulating layer 120 may include an inorganic insulating material such as silicon oxide (SiOx) and silicon nitride (SiNx). The gate insulating layer 120 may include a material having a high dielectric constant. For example, the gate insulating layer 120 may include a high-k material such as hafnium oxide (HfO). The gate insulating layer 120 may have a multi-layered structure.

Gate lines (not shown) connected to the gate electrodes 213 and 223 may be disposed on the gate insulating layer 120.

The interlayer insulating layer 130 may include an inorganic insulating material such as silicon oxide (SiOx) and silicon nitride (SiNx). The interlayer insulating layer 130 may have a multi-layered structure.

Data lines (not shown) and power lines (not shown), which are connected to the source electrodes 215 and 225 or the drain electrodes 217 and 227, may be disposed on the interlayer insulating layer 130.

The passivation layer 140 and the planarization layer 150 may be stacked on the first and second emission control transistors ET1 and ET2. The passivation layer 140 may include an inorganic insulating material such as silicon oxide (SiOx) and silicon nitride (SiNx). The planarization layer 150 may include an organic insulating material different from the passivation layer 140, and may provide a flat surface.

A light-emitting element layer, which includes (1-1)th, (1-2)th, (2-1)th and (2-2)th light-emitting elements EL11, EL12, EL21 and EL22, may be disposed on the planarization layer 150.

The (1-1)th and (1-2)th light-emitting elements EL11 and EL12 include a first shared anode electrode RAE1 disposed on the planarization layer 150, a light-emitting layer 312 disposed on the first shared anode electrode RAE1, and a cathode electrode 313 disposed on the light-emitting layer 312. The (2-1)th and (2-2)th light-emitting elements EL21 and EL22 include a (2-1)th anode electrode RAE21 and a (2-2)th anode electrode RAE22, which are disposed on the planarization layer 150, a light emitting layer 322 on each of the (2-1)th anode electrode RAE21 and the (2-2)th anode electrode RAE22, and a cathode electrode 323 disposed on the light emitting layer 322. The (1-1)th and (1-2)th light-emitting elements EL11 and EL12 and the (2-1)th and (2-2)th light-emitting elements EL21 and EL22, which are disposed in the respective subpixel areas RPA1 and RPA2, may emit light of the same color.

The first shared anode electrode RAE1 of the (1-1)th light-emitting element EL11 may be connected to any one of the source electrode 215 and the drain electrode 217 of the first emission control transistor ET1 through a contact hole passing through the planarization layer 150 and the passivation layer 140. The first shared anode electrode RAE1 of the (1-2)th light-emitting element EL12 may be connected to any one of the source electrode 225 and the drain electrode 227 of the second emission control transistor ET2 through the contact hole passing through the planarization layer 150 and the passivation layer 140. The first anode electrode RAE21 of the (2-1)th light-emitting element EL21 may be connected to any one of the source electrode 215 and the drain electrode 217 of the first emission control transistor ET1 through the contact hole passing through the planarization layer 150 and the passivation layer 140. The first anode electrode RAE22 of the (2-2)th light-emitting element EL22 may be connected to any one of the source electrode 225 and the drain electrode 227 of the second emission control transistor ET2 through the contact hole passing through the planarization layer 150 and the passivation layer 140.

The shared anode electrode RAE1 and the anode electrodes RAE21 and RAE22 may include a conductive material having high reflectivity. The shared anode electrode RAE1 and the anode electrodes RAE21 and RAE22 may include a metal such as aluminum (Al), silver (Ag), titanium (Ti) and silver-palladium-copper (APC) alloy. The shared anode electrode RAE1 and the anode electrodes RAE21 and RAE22 may further include a transparent conductive material such as indium tin oxide (ITO) or indium zinc oxide (IZO). For example, the shared anode electrode RAE1 and the anode electrodes RAE21 and RAE22 may have a multi-layered structure (Ti/Al/Ti) of titanium (Ti) and aluminum (Al), a multi-layered structure (ITO/Al/ITO) of ITO and aluminum (Al) or a multi-layered structure (ITO/APC/ITO) of ITO and APC.

The light-emitting layers 312 and 322 may include an emission material layer (EML) including a light-emitting material. The light-emitting material may include an organic material, an inorganic material or a hybrid material. The light-emitting layer 312 of the (1-1)th light-emitting element EL11 and the light-emitting layer 312 of the (1-2)th light-emitting element EL12 may be spaced apart from or connected to each other. The light-emitting layer 322 of the (2-1)th light-emitting element EL21 and the light-emitting layer 322 of the (2-2)th light-emitting element EL22 may be spaced apart from each other.

The light-emitting layers 312 and 322 may have a multi-layered structure. For example, the light-emitting layers 312 and 322 may further include at least one of a hole injection layer (HIL), a hole transport layer (HTL), an electron transport layer (ETL) or an electron injection layer (EIL).

The cathode electrodes 313 and 323 may be common electrodes and include a conductive material for transmitting light. The cathode electrodes 313 and 323 may include a transparent conductive material such as ITO or IZO. The cathode electrodes 313 and 323 may include Al, Mg, Ag or their alloy, and may have a thin thickness capable of transmitting light. Therefore, the light generated from each of the light-emitting layers 312 and 322 may be emitted through each of the cathode electrodes 313 and 323.

A bank insulating layer 160 may be positioned on the shared anode electrode RAE1 of the (1-1)th and (1-2)th light-emitting elements EL11 and EL12. The (2-1)th anode electrode RAE21 of the (2-1)th light-emitting element EL21 may be spaced apart from the (2-2)th anode electrode RAE22 of the (2-2)th light-emitting element EL22, and the bank insulating layer 160 may be positioned between the (2-1)th and (2-2)th anode electrodes RAE21 and RAE22. The bank insulating layer 160 may cover edges of each of the shared anode electrode RAE1 and the (2-1)th and (2-2)th anode electrodes RAE21 and RAE22. The bank insulating layer 160 may include an organic insulating material. The bank insulating layer 160 may include an organic material different from that of the planarization layer 150, and may have a single layered structure or a double layered structure.

The bank insulating layer 160 may include a plurality of openings through which the shared anode electrode RAE1 of the (1-1)th and (1-2)th light-emitting elements EL11 and EL12 is exposed, thereby defining the plurality of light emission areas RE11 and RE12. The light-emitting layer 312 and the second electrode 313 of the (1-1)th and (1-2)th light-emitting elements EL11 and EL12 may be stacked on the shared anode electrode RAE1 exposed by the openings of the bank insulating layer 160.

The bank insulating layer 160 may include a plurality of openings through which the (2-1)th and (2-2)th anode electrodes RAE21 and RAE22 of the (2-1)th and (2-2)th light-emitting elements EL21 and EL22 are exposed, thereby defining the (2-1)th and (2-2)th light emission areas RE21 and RE22. The light-emitting layer 322 and the second electrode 323 of the (2-1)th and (2-2)th light-emitting elements EL21 and EL22 may be stacked on the (2-1)th and (2-2)th anode electrodes RAE21 and RAE22 exposed by the openings of the bank insulating layer 160.

The encapsulation layer 800 may be positioned on the light-emitting element layer that includes the light-emitting elements EL11, EL12, EL21 and EL22 of the subpixel areas RPA1 and RPA2. The encapsulation layer 800 may prevent the light-emitting elements EL11, EL12, EL21 and EL22 from being damaged due to moisture and impact from the outside. The encapsulation layer 800 may have a multi-layered structure. For example, the encapsulation layer 800 may include a first encapsulation layer 810, a second encapsulation layer 820 and a third encapsulation layer 830, which are sequentially stacked, and the embodiments of the present disclosure are not limited thereto. The first encapsulation layer 810, the second encapsulation layer 820 and the third encapsulation layer 830 may include an insulating material. The second encapsulation layer 820 may include a material different from that of the first encapsulation layer 810 and the third encapsulation layer 830. For example, the first encapsulation layer 810 and the third encapsulation layer 830 may be inorganic encapsulation layers that include an inorganic insulating material, and the second encapsulation layer 820 may include an organic encapsulation layer that includes an organic insulating material. Therefore, the light-emitting elements EL1 and EL2 of the display apparatus may be prevented from being damaged due to moisture and impact from the outside.

The touch sensor layer 900 may be disposed on the encapsulation member 800 of the subpixel areas RPA1 and RPA2. The touch sensor layer 900 may include a touch insulating layer 910 disposed on the encapsulation layer 800, a bridge electrode 920 disposed on the touch insulating layer 910, a black matrix 930 covering the bridge electrode 920, a touch interlayer insulating layer 940 covering the black matrix 930, a touch sensor electrode 950 disposed on the touch interlayer insulating layer 940, and a touch passivation film 960 covering the touch sensor electrode 950. The bridge electrode 920, the black matrix 930 and the touch sensor electrode 950 may be disposed in a non-light emission area that overlaps the bank insulating layer 160.

A lens layer, which includes a first lens area LZ1 and a second lens area LZ2, may be disposed on the touch sensor layer 900.

The first lens area LZ1 may be disposed on each of the (1-1)th light emission area RE11 of the (1-1)th light-emitting element EL11, the (1-2)th light emission area RE12 of the (1-2)th light-emitting element EL12 and the (2-1)th light emission area RE21 of the (2-1)th light-emitting element EL21 to control a moving path of light generated from the (1-1)th light emission area RE11, the (1-2)th light emission area RE12 and the (2-1)th light emission area RE21.

The first lens area LZ1 may control the moving path of the light generated from each of the (1-1)th light emission area RE11, the (1-2)th light emission area RE12 and the (2-1)th light emission area RE21 at a wide viewing angle having a first specific angle in the left-right direction X, and may control the light at a narrow viewing angle having a second specific angle smaller than the first specific angle in the up and down direction Y.

In one embodiment, the first lens area LZ1 that overlaps each of the (1-1)th light emission area RE11 of the (1-1)th light-emitting element EL11 and the (2-1)th light emission area RE21 of the (2-1)th light emitting element EL21 may emit light L1 of the wide viewing angle having a first specific angle in the left-right direction X as shown in FIG. 9.

In one embodiment, as shown in FIG. 10, the first lens area LZ1, which overlaps each of the (1-2)th light emission areas RE12 may emit light L2 having a third specific angle by limiting a viewing angle in the left-right direction by a barrier layer 970 that overlaps the black matrix 930 as shown in FIG. 10. The third specific angle may be smaller than the first specific angle and greater than the second specific angle. The barrier layer 970 may be disposed on the touch sensor layer 900 to overlap the first lens area LZ1 and may be also disposed to overlap the black matrix 930.

The second lens area LZ2 may be disposed on the (2-2)th light emission area RE22 of the (2-2)th light-emitting element EL22 to control the moving path of the light generated from the (2-2)th light emission area RE22.

The second lens area LZ2 may control the moving path of the light generated from the (2-2)th light emission area RE22 at a narrow viewing angle having a second specific angle smaller than the first specific angle in the left-right direction X and the up and down direction Y.

In one embodiment, as shown in FIG. 11, the second lens area LZ2 that overlaps the (2-2)th light emission area RE22 may emit light L3 having a narrow viewing angle of a second specific angle by limiting a viewing angle in the left-right direction by the barrier layer 970 that overlaps the black matrix 930 as shown in FIG. 11. The barrier layer 970 may be disposed on the touch sensor layer 900 to adjoin the second lens area LZ2, and may be disposed to overlap the black matrix 930.

A lens passivation layer 600 may be positioned on the first lens area LZ1 and the second lens area LZ2. The lens passivation layer 600 may include an organic insulating material. A refractive index of the lens passivation layer 600 may be smaller than a refractive index of the first lens area LZ1 and a refractive index of the second lens area LZ2. Therefore, light passing through the first lens area LZ1 and the second lens area LZ2 may not be reflected toward the substrate 101 due to a difference in refractive index from the lens passivation layer 600.

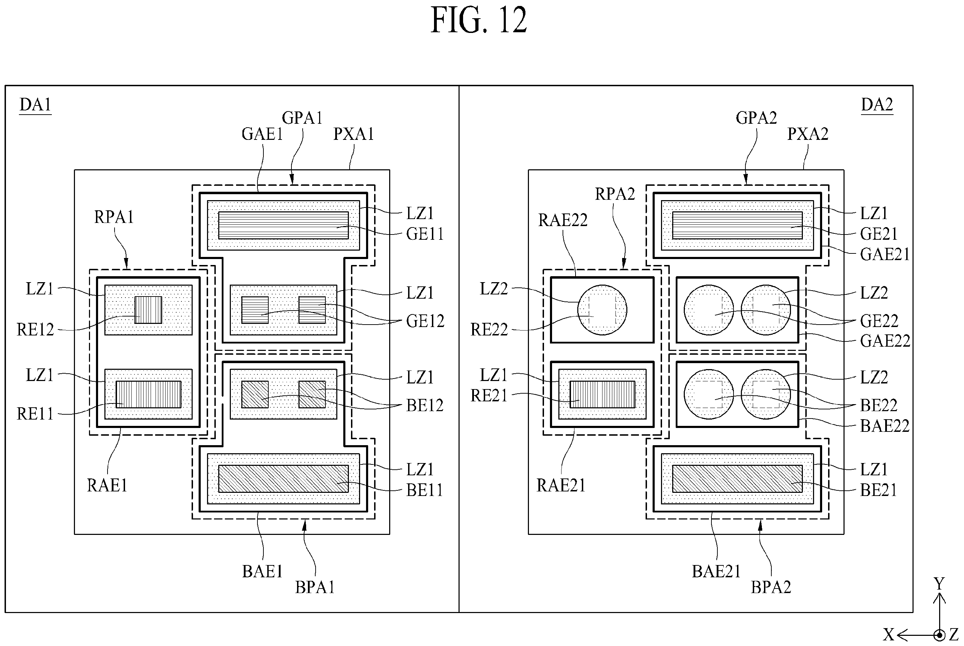

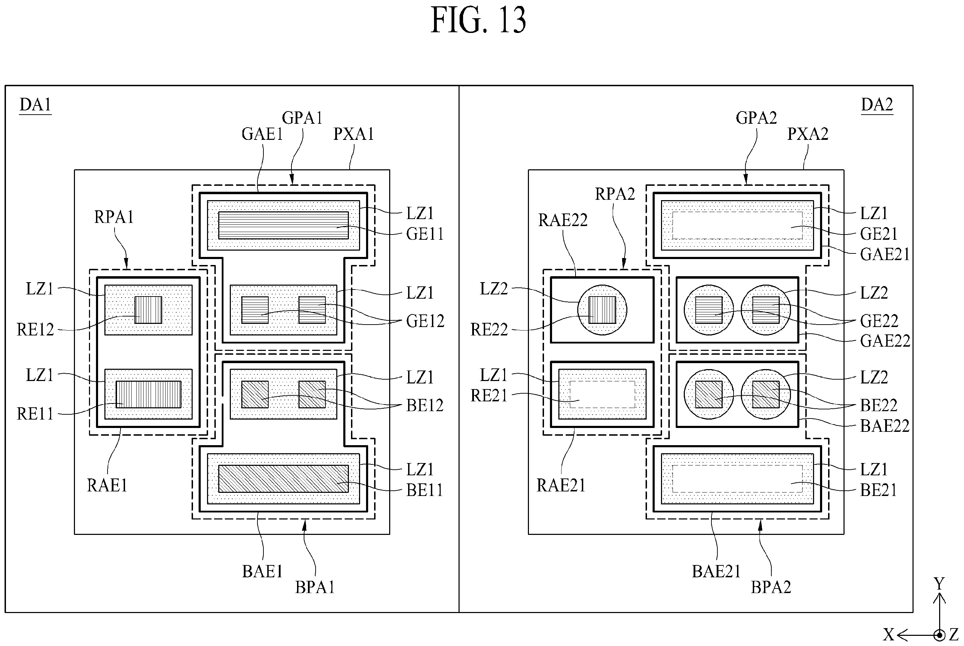

FIGS. 12 and 13 are views illustrating a method for controlling a viewing angle of a display panel according to one embodiment.

Referring to FIG. 12, the second type pixel area PXA2 disposed in the second area DA2 may emit light of the (2-1)th light emission areas RE21, GE21 and BE21 of the (2-1)th light-emitting elements in response to the control of the first emission control signal activated in the wide viewing angle mode, thereby controlling the viewing angle in the left-right direction X at the wide viewing angle through the first lens area LZ1.

The first type pixel area PXA1 of the first area DA1 may emit light of the (1-1)th and (1-2)th light emission areas RE11, GE11, BE11, RE12, GE12 and BE12 of the (1-1)th and (1-2)th light emitting element connected to the shared anode electrodes RAE1, GAE1 and BAE1 in response to the control of the first emission control signal which is the same as that of the second area DA2, thereby controlling the viewing angle in the left-right direction X at the wide viewing angle through the first lens area LZ1.

Referring to FIG. 13, the second type pixel area PXA2 disposed in the second area DA2 may emits light of the (2-2)th light emission areas RE22, GE22 and BE22 of the (2-2)the light-emitting elements in response to the control of the second emission control signal activated in the narrow viewing angle mode, thereby controlling the viewing angle in the left-right direction X at the narrow viewing angle through the second lens area LZ2.

The first type pixel area PXA1 of the first area DA1 may emit light of the (1-1)th and (1-2)th light emission areas RE11, GE11, BE11, RE12, GE12 and BE12 of the (1-1)th and (1-2)th light-emitting elements connected to the shared anode electrodes RAE1, GAE1 and BAE1 in response to the control of the second emission control signal which is the same as that of the second area DA2, thereby controlling the viewing angle in the left-right direction X at the wide viewing angle through the first lens area LZ1.

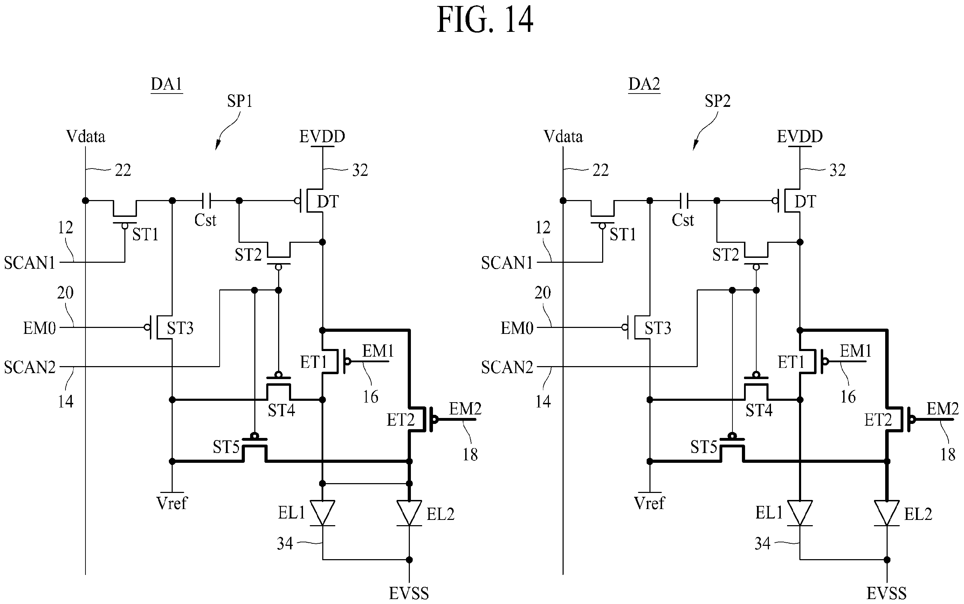

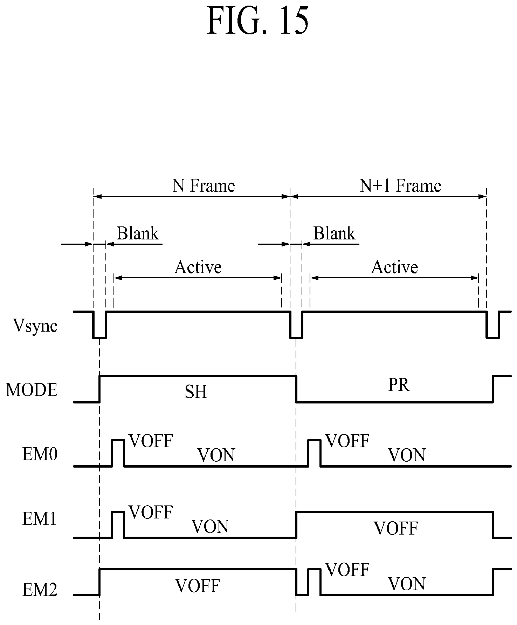

FIG. 14 is an equivalent circuit view illustrating a configuration of first and second type subpixels in a display panel according to one embodiment, and FIG. 15 is an exemplary view illustrating driving waveforms of first and second type subpixels in a display panel according to one embodiment. In FIG. 14, "SP1" refers to a first type subpixel. In an embodiment, first type subpixel "SP 1" in FIG. 14 may correspond to the first type subpixel "SP11" described herein above, and first and second light-emitting elements "EL1" and "EL2" of first type subpixel "SP1" in FIG. 14 may correspond, respectively, to first and second light-emitting elements "EL11" and "EL12" described herein above. Similarly, "SP2" in FIG. 14 refers to a second type subpixel. In an embodiment, second type subpixel "SP2" in FIG. 14 may correspond to second type subpixel "SP21" described herein above, and first and second light-emitting elements "EL1" and "EL2" of second type subpixel "SP2" in FIG. 14 may correspond, respectively, to first and second light-emitting elements "EL21" and "EL22" described herein above.

Referring to FIG. 14, each of the first type subpixel SP1 disposed in the first area DA1 and the second type subpixel SP2 disposed in the second area DA2 may include a pixel circuit that includes a plurality of transistors DT, ST1 to ST5, ET1 and ET2 and first and second light-emitting elements EL1 and EL2. The first and second light-emitting elements EL1 and EL2 of the first type subpixel SP1 may have a structure in which an anode electrode is connected, and the first and second light-emitting elements EL1 and EL2 of the second type subpixel SP2 may have a structure in which an anode electrode is separated. The first lens area LZ1 may be disposed on the light emission area of each of the first and second light-emitting elements EL1 and EL2 of the first type subpixel SP1. The first lens area LZ1 may be disposed on the first light-emitting element EL1 of the second type subpixel SP2, and the second lens area LZ2 may be disposed on the second light-emitting element EL2.

The pixel circuit of each of the subpixels SP1 and SP2 shown in FIG. 14 may include five switching transistors ST1 to ST5, a driving transistor DT, a storage capacitor Cst, first and second emission control transistors ET1 and ET2 and first and second light-emitting elements EL1 and EL2, but is not limited to this configuration.

Referring to FIG. 14, the pixel circuit of each of the subpixels SP1 to SP2 may be driven so that each of frame periods N and N+1 includes an initialization period, a sampling period, a program period and an emission period. Each of the frame periods N and N+1 may be distinguished by being synchronized with a vertical synchronization signal Vsync, and may include a blank period and an active period.

Referring to FIG. 15, when a voltage level of a mode control signal MODE indicates a wide viewing angle mode or a share mode SH, a first emission control signal EM1 may be activated by a gate-on voltage VON during an initialization period and an emission period of each frame period, and a second emission control signal EM2 may be deactivated by the gate-off voltage VOFF. The first emission control signal EM1 may be deactivated by the gate-off voltage VOFF during the sampling and program periods of each frame period.

When the voltage level of the mode control signal MODE indicates a narrow viewing angle mode or a privacy mode PR, the second emission control signal EM2 may be activated by the gate-on voltage VON during the initialization period and the emission period of each frame period, and the first emission control signal EM1 may be deactivated by the gate-off voltage VOFF. The second emission control signal EM2 may be deactivated by the gate-off voltage VOFF during the sampling and program periods of each frame period.

An emission control signal EM0 may be activated by the gate-on voltage VON during the initialization period and the emission period of each frame period, and may be deactivated by the gate-off voltage VOFF during the sampling and program periods.

Voltage levels of the first and second emission control signals EM1 and EM2 may be inverted in accordance with the mode control signal MODE during the blank period.

In each of the subpixels SP1 and SP2, light emission of the first light-emitting element EL1 may be controlled by the first emission control transistor ET1 controlled by the first emission control signal EM1, and light emission of the second light-emitting element EL2 may be controlled by the second emission control transistor ET2 controlled by the second emission control signal EM2.

Each of the transistors DT, ST1 to ST5, ET1 and ET2 of the subpixels SP1 and SP2 includes a gate electrode, a source electrode and a drain electrode. Since the source electrode and the drain electrode may be changed depending on a voltage applied to the gate electrode and a current direction without being fixed, any one of the source electrode and the drain electrode may be expressed as a first electrode, and the other one may be expressed as a second electrode. The transistors DT, ST1 to ST5, ET1 and ET2 of the subpixels SP1 and SP2 may use at least one of a polysilicon semiconductor, an amorphous silicon semiconductor or an oxide semiconductor. The transistors may be P-type or N-type transistors, or P-type and N-type transistors may be used interchangeably.

Each of the light-emitting elements EL1 and EL2 may include an anode electrode individually connected to each of the emission control transistors ET1 and ET2, a cathode electrode supplied with a second power voltage EVSS from the second power line 34, and a light-emitting layer between the anode electrode and the cathode electrode. When each of the light-emitting elements EL1 and EL2 is supplied with a driving current from the driving transistor DT through each of the emission control transistors ET1 and ET2, electrons from the cathode electrode may be injected into the light-emitting layer and holes from the anode electrode may be injected into the organic light-emitting layer so that fluorescent or phosphorescent materials may emit light through recombination of the electrons and the holes in the light-emitting layer, thereby generating light of brightness proportional to a current value of the driving current.

The first electrode of the driving transistor DT may be connected to the first power line 32 for supplying the first power voltage EVDD. The first power voltage EVDD may be supplied from the power management circuit 700. The second electrode of the driving transistor DT may be commonly connected to the first electrodes of the first and second emission control transistors ET1 and ET2. The driving transistor DT may drive the first light-emitting element EL1 through the first emission control transistor ET1, or may drive the second light-emitting element EL2 through the second emission control transistor ET2. The driving transistor DT may control the emission intensity of the first light-emitting element EL1 or the second light-emitting element EL2 through the first emission control transistor ET1 or the second emission control transistor ET2 by controlling a driving current Ids in accordance with a driving voltage Vgs of the storage capacitor Cst.

The storage capacitor Cst may be connected between the gate electrode and the first electrode of the driving transistor DT and charge the driving voltage Vgs corresponding to the data voltage Vdata. The storage capacitor Cst may hold the charged driving voltage Vgs during the emission period at which the first switching transistor ST1 is turned off, thereby supplying the driving voltage to the driving transistor DT.

The first switching transistor ST1 may be turned on or off in response to a first scan signal SCAN1 supplied to a first gate line 12 disposed in an (N)th (N is a natural number) pixel row line. The first switching transistor ST1 may supply the data voltage Vdata supplied through the data line 22 to the first electrode of the storage capacitor Cst during the sampling and program periods in response to the first scan signal SCAN1. The first scan signal SCAN1 may be supplied from the scan driver (210 in FIG. 1).

The second, fourth and fifth switching transistors ST2, ST4 and ST5 may be turned on or off in response to a second scan signal SCAN2 supplied to a second gate line 14 disposed in the (N)th pixel row line. The second scan signal SCAN2 may be supplied from the scan driver (210 in FIG. 1).

The second switching transistor ST2 may connect the gate electrode of the driving transistor DT with the second electrode (or drain electrode) of the driving transistor DT in response to the second scan signal SCAN2 during the initialization period and the sampling and program periods, thereby connecting the driving transistor DT to a diode structure (in other words, the driving transistor DT may be diode-connected when the second switching transistor ST2 is turned on). The second switching transistor ST2 may charge a threshold voltage Vth of the driving transistor DT in the storage capacitor Cst and compensate for the threshold voltage Vth. Therefore, the storage capacitor Cst may charge the data voltage Vdata+Vth, for which the threshold voltage Vth of the driving transistor DT is compensated, during the sampling and program periods.

The fourth switching transistor ST4 may supply the initialization voltage Vref (or the reference voltage) supplied through the initialization voltage line 24 to the anode electrode of the first light-emitting element EL1 in response to the second scan signal SCAN2 during the initialization period and the sampling and program periods.

The fifth switching transistor ST5 may supply the initialization voltage Vref supplied through the initialization voltage line 24 to the anode electrode of the second light-emitting element EL2 in response to the second scan signal SCAN2 during the initialization period and the sampling and program periods.

The third switching transistor ST3 may be turned on or off in response to the emission control signal EM0 supplied to a third gate line 20 disposed in the (N)th pixel row line. The emission control signal EM0 may be supplied from the emission control driver (220 of FIG. 1).

The third switching transistor ST3 may supply the initialization voltage Vref supplied through the initialization voltage line 24 to the first electrode of the storage capacitor Cst in response to the emission control signal EM0 during the initialization period and the emission period.

The first emission control transistor ET1 may be turned on or off by being controlled by the first emission control signal EM1 supplied to a fourth gate line 16, and the second emission control transistor ET2 may be turned on or off by being controlled by the second emission control signal EM2 supplied to a fifth gate line 18.

In the wide viewing angle mode or the share mode, the first emission control transistor ET1 may connect the driving transistor DT with the first light-emitting element EL1 during the initialization period and the emission period at which the first emission control signal EM1 is activated by the gate-on voltage VON. Therefore, the first light-emitting element EL1 may be driven by the driving current from the driving transistor DT to emit light. As a result, the second type subpixel SP2 may emit light at a wide viewing angle through the first lens LZ1 due to the light emission of the first light-emitting element EL1, and the first type subpixel SP1 may emit light at a wide viewing angle through the first lens LZ1 due to the light emission of the first and second light-emitting elements EL1 and EL2.

In the narrow viewing angle mode or the privacy mode, the second emission control transistor ET2 may connect the driving transistor DT with the second light-emitting element EL2 during the initialization period and the emission period at which the second emission control signal EM2 is activated by the gate-on voltage VON. Therefore, the second light-emitting element EL2 may be driven by the driving current from the driving transistor DT to emit light. As a result, the second type subpixel SP2 may emit light at a narrow viewing angle through the second lens LZ2 due to the light emission of the second light-emitting element EL2, and the first type subpixel SP1 may emit light at a wide viewing angle through the first lens LZ1 due to the light emission of the first and second light-emitting elements EL1 and EL2.

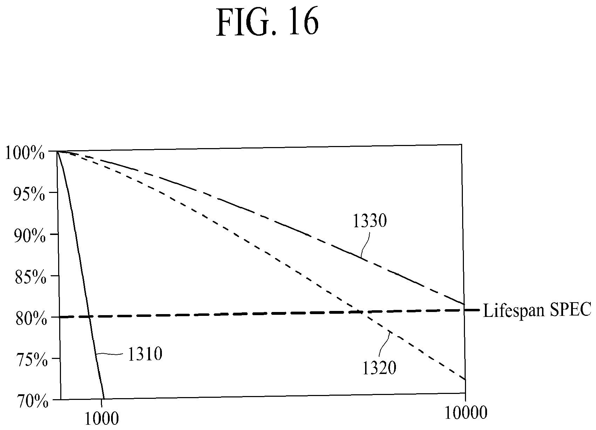

FIG. 16 is a graph illustrating a lifespan improvement effect of a display apparatus according to one embodiment.

Referring to FIG. 16, when the anode electrodes of the first and second light-emitting elements are separated from the first type subpixel, a room-temperature lifespan trend 1310 of the second light-emitting element having a small second light emission area and a room-temperature lifespan trend 1320 of the first light-emitting element having the first light emission area larger than the second light emission area have a small light emission area so that a current density may be increased, whereby it is noted that the current density is lower than a horizontal spec criterion SPEC.

On the other hand, when the first and second light-emitting elements share the anode electrode in the first type subpixel like the display apparatus according to one embodiment, the first and second light-emitting elements may simultaneously emit light so that the light emission area is increased in the first and second light emission areas and the current density is reduced due to the increase in the light emission area, whereby it is noted that the room-temperature horizontal trend 1330 is more improved than the horizontal spec criterion SPEC.

According to the present disclosure, the following advantageous effects may be obtained.

In the display panel and the display apparatus according to some embodiments, the first and second light-emitting elements of the first type subpixel may share the anode electrode in the first area of the wide viewing angle mode to simultaneously emit light, so that the light emission area of the first type subpixel may be increased, and the current density may be reduced by the increase of the light emission area, whereby the light-emitting elements of the first type subpixel may be reduced and lifespan thereof may be increased.

In the display panel and the display apparatus according to some embodiments, degradation of the light-emitting elements may be reduced due to the decrease of the current density in the first area, so that luminance and color sense defects due to degradation may be resolved and power consumption for degradation compensation may be reduced.

A display panel according to some aspects may include a display area divided into a first area in which a first type subpixel is disposed and a second area in which a second type subpixel is disposed, wherein each of the first type subpixel and the second type subpixel may include a first light-emitting element driven through a first emission control transistor and a second light-emitting element driven through a second emission control transistor, and the first and second light-emitting elements of the first type subpixel share an anode electrode.

In the display panel according to some aspects, the first type subpixel may include a (1-1)th lens area disposed on a (1-1)th light emission area of the first light-emitting element of the first type subpixel, and a (1-2)th lens area disposed on a (1-2)th light emission area of the second light-emitting element of the first type subpixel, and the (1-1)th lens area and the (1-2)th lens area may control a viewing angle in a first direction at a wide viewing angle having a first specific angle.

In the display panel according to some aspects, the second type subpixel may include a first lens area disposed on a (2-1)th light emission area of the first light-emitting element of the second type subpixel, and a second lens area disposed on a (2-2)th light emission area of the second light-emitting element of the second type subpixel, the first lens area may control the viewing angle in the first direction at the wide viewing angle, and the second lens area may control the viewing angle in the first direction at a narrow viewing angle smaller than the first specific angle.

In the display panel according to some aspects, the first type subpixel may further include a barrier disposed on a non-light emission area adjacent to the (1-2)th light emission area to limit the viewing angle in the first direction.

In the display panel according to some aspects, when a first emission control signal for controlling the first emission control transistor is activated, the first and second light-emitting elements of the first type subpixel may simultaneously emit light and the first light-emitting element of the second type subpixel may emit light, and the first and second areas may be driven in a wide viewing angle mode.

In the display panel according to some aspects, when a second emission control signal for controlling the second emission control transistor is activated, the first and second light-emitting elements of the first type subpixel may simultaneously emit light and the second light-emitting element of the second type subpixel may emit light, and the first area may be driven in the wide viewing angle mode and the second area may be driven in a narrow viewing angle mode.

In the display panel according to some aspects, each of the first and second type subpixels may include a driving transistor commonly connected to the first and second emission control transistors, a storage capacitor connected to a gate electrode of the driving transistor, a first switching transistor supplying a data voltage of a data line to a first electrode of the storage capacitor in response to a first scan signal of a first gate line, a second switching transistor connecting the driving transistor to a diode structure in response to a second scan signal of a second gate line (that is, the driving transistor may be diode-connected by the second switching transistor when the second switching transistor is turned on by the second scan signal), a third switching transistor supplying an initialization voltage of an initialization voltage line to the first electrode of the storage capacitor in response to an emission control signal of a third gate line, a fourth switching transistor supplying the initialization voltage of the initialization voltage line to the anode electrode of the first light-emitting element in response to the second scan signal of the second gate line, and a fifth switching transistor supplying the initialization voltage of the initialization voltage line to the anode electrode of the second light-emitting element in response to the second scan signal of the second gate line.

In the display panel according to some aspects, the first type subpixel may be one of a plurality of first type subpixels disposed in the first area, the plurality of first type subpixels may include a (1-1)th colored subpixel, a (1-2)th colored subpixel and a (1-3)th colored subpixel, a size of the (1-1)th lens area disposed on the (1-1)th light emission area of at least one subpixel of the (1-1)th colored subpixel, the (1-2)th colored subpixel or the (1-3)th colored subpixel may be different from a size of the (1-1)th lens area of another subpixel of the plurality of first type subpixels, and the number of the (1-2)th light emission areas of at least one subpixel of the (1-1)th colored subpixel, the (1-2)th colored subpixel or the (1-3)th colored subpixel may be different from the number of the (1-2)th light emission areas of another subpixel of the plurality of first type subpixels.

In the display panel according to some aspects, the second type subpixel may be one of a plurality of second type subpixels disposed in the second area, the plurality of second type subpixels may include a (2-1)th colored subpixel, a (2-2)th colored subpixel and a (2-3)th colored subpixel, a size of the first lens area disposed on the (2-1)th light emission area of at least one subpixel of the (2-1)th colored subpixel, the (2-2)th colored subpixel or the (2-3)th colored subpixel may be different from a size of the first lens area of another subpixel of the plurality of second type subpixels, and the number of the second lens areas disposed on the (2-2)th light emission area of at least one subpixel of the (2-1)th colored subpixel, the (2-2)th colored subpixel or the (2-3)th colored subpixel may be different from the number of the second lens areas of another subpixel of the plurality of second type subpixels.

A display apparatus according to some aspects may include the display panel according to one or more aspects described herein above; and a gate driver disposed in a bezel area outside the display area in the display panel to drive gate lines connected to the first type subpixel and the second type subpixel, wherein the gate driver may include an emission control driver controlling the first and second emission control transistors of the display panel.

In the display apparatus according to some aspects, the gate driver further includes a scan driver outputting the first and second scan signals to the first and second gate lines.

A display apparatus according to some aspects may include a display panel including a display area divided into a first area in which a first type subpixel is disposed and a second area in which a second type subpixel is disposed, and a gate driver disposed in a bezel area outside the display area in the display panel to drive gate lines connected to the first type subpixel and the second type subpixel, wherein each of the first type subpixel and the second type subpixel may include a first light-emitting element driven through a first emission control transistor and a second light-emitting element driven through a second emission control transistor, the first and second light-emitting elements of the first type subpixel share an anode electrode, and the gate driver includes an emission control driver controlling the first and second emission control transistors.

In the display apparatus according to some aspects, the first type subpixel may include a (1-1)th lens area disposed on a (1-1)th light emission area of the first light-emitting element of the first type subpixel, and a (1-2)th lens area disposed on a (1-2)th light emission area of the second light-emitting element of the first type subpixel, and the (1-1)th lens area and the (1-2)th lens area may control a viewing angle in a first direction at a wide viewing angle having a first specific angle.

In the display apparatus according to some aspects, the second type subpixel may include a first lens area disposed on a (2-1)th light emission area of the first light-emitting element of the second type subpixel, and a second lens area disposed on a (2-2)th light emission area of the second light-emitting element of the second type subpixel, the first lens area may control the viewing angle in the first direction at the wide viewing angle, and the second lens area may control the viewing angle in the first direction at a narrow viewing angle smaller than the first specific angle.

In the display apparatus according to some aspects, the first type subpixel may further include a barrier disposed on a non-light emission area adj acent to the (1-2)th light emission area to limit the viewing angle in the first direction.

In the display apparatus according to some aspects, when a first emission control signal for controlling the first emission control transistor is activated, the first and second light-emitting elements of the first type subpixel may simultaneously emit light and the first light-emitting element of the second type subpixel emits light, and the first and second areas may be driven in a wide viewing angle mode.

In the display apparatus according to some aspects, when a second emission control signal for controlling the second emission control transistor is activated, the first and second light-emitting elements of the first type subpixel may simultaneously emit light and the second light-emitting element of the second type subpixel emits light, and the first area may be driven in the wide viewing angle mode and the second area may be driven in a narrow viewing angle mode.

In the display apparatus according to some aspects, each of the first and second type subpixels may include a driving transistor commonly connected to the first and second emission control transistors, a storage capacitor connected to a gate electrode of the driving transistor, a first switching transistor supplying a data voltage of a data line to a first electrode of the storage capacitor in response to a first scan signal of a first gate line, a second switching transistor connecting the driving transistor to a diode structure in response to a second scan signal of a second gate line (that is, the driving transistor may be diode-connected by the second switching transistor when the second switching transistor is turned on by the second scan signal), a third switching transistor supplying an initialization voltage of an initialization voltage line to the first electrode of the storage capacitor in response to an emission control signal supplied from the emission control driver to a third gate line, a fourth switching transistor supplying the initialization voltage of the initialization voltage line to the anode electrode of the first light-emitting element in response to the second scan signal of the second gate line, and a fifth switching transistor supplying the initialization voltage of the initialization voltage line to the anode electrode of the second light-emitting element in response to the second scan signal of the second gate line.

In the display apparatus according to some aspects, the gate driver may further include a scan driver outputting the first and second scan signals to the first and second gate lines.

The above-described feature, structure, and effect of the present disclosure are included in at least one embodiment of the present disclosure, but are not limited to only one embodiment. Furthermore, the feature, structure, and effect described in at least one embodiment of the present disclosure may be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the spirit or scope of the disclosures. Thus, it is intended that the present disclosure covers the modifications and variations of this disclosure provided they come within the scope of the appended claims.

## Claims

1. A display panel (100) comprising a display area (DA) divided into a first area (DA1) in which a first type subpixel (SP1, SP11) is disposed and a second area (DA2) in which a second type subpixel (SP2, SP21) is disposed,
wherein each of the first type subpixel (SP1, SP11) and the second type subpixel (SP2, SP21) includes
a first light-emitting element (EL1, EL11, EL21) driven through a first emission control transistor (ET1) and a second light-emitting element (EL2, EL12, EL22) driven through a second emission control transistor (ET2), and
the first and second light-emitting elements (EL1, E2; EL11, EL12) of the first type subpixel (SP11) share an anode electrode (AE1).

2. The display panel (100) of claim 1, wherein the first type subpixel (SP11) includes:
a (1-1)th lens area (LZ1) disposed on a (1-1)th light emission area (RE11, GE11, BE11) of the first light-emitting element (EL11) of the first type subpixel (SP11); and
a (1-2)th lens area (LZ1) disposed on a (1-2)th light emission area (RE12, GE12, BE12) of the second light-emitting element (EL12) of the first type subpixel (SP11), and
the (1-1)th lens area (LZ1) and the (1-2)th lens area (LZ1) are configured to control a viewing angle in a first direction at a wide viewing angle having a first specific angle.

3. The display panel (100) of claim 2, wherein the second type subpixel (SP21) includes:
a first lens area (LZ1) disposed on a (2-1)th light emission area (RE21, GE21, BE21) of the first light-emitting element (EL21) of the second type subpixel (SP21); and
a second lens area (LZ2) disposed on a (2-2)th light emission area (RE22, GE22, BE22) of the second light-emitting element (EL22) of the second type subpixel (SP21),
wherein the first lens area (LZ1) is configured to control the viewing angle in the first direction at the wide viewing angle, and
the second lens area (LZ2) is configured to control the viewing angle in the first direction at a narrow viewing angle smaller than the first specific angle.

4. The display panel (100) of claim 2 or 3, wherein the first type subpixel (SP11) further includes a barrier (970) disposed on a non-light emission area adjacent to the (1-2)th light emission area (RE12, GE12, BE12) to limit the viewing angle in the first direction.

5. The display panel (100) of any of claims 1 to 4, further configured such that, when a first emission control signal (EM1) for controlling the first emission control transistor (ET1) is activated, the first and second light-emitting elements (EL1, EL2; EL11, EL12) of the first type subpixel (SP1, SP11) simultaneously emit light and the first light-emitting element (EL1, EL21) of the second type subpixel (SP2, SP21) emits light, and
the first and second areas (DA1, DA2) are driven in a wide viewing angle mode.

6. The display panel (100) of claim 5, further configured such that, when a second emission control signal (EM2) for controlling the second emission control transistor (ET2) is activated, the first and second light-emitting elements (EL1, EL2; EL11, EL12) of the first type subpixel (SP1, SP11) simultaneously emit light and the second light-emitting element (EL2, EL22) of the second type subpixel (SP2, SP21) emits light, and
the first area (DA1) is driven in the wide viewing angle mode and the second area (DA2) is driven in a narrow viewing angle mode.

7. The display panel (100) of any of claims 1 to 6, wherein each of the first and second type subpixels (SP1, SP2; SP11, SP21) includes:
a driving transistor (DT) commonly connected to the first and second emission control transistors (ET2);
a storage capacitor (Cst) connected to a gate electrode of the driving transistor (DT);
a first switching transistor (ST1) configured to supply a data voltage (Vdata) of a data line (22) to a first electrode of the storage capacitor (Cst) in response to a first scan signal (SCAN1) of a first gate line (12);
a second switching transistor (ST2) configured to connect the driving transistor (DT) to a diode structure in response to a second scan signal (SCAN2) of a second gate line (14);
a third switching transistor (ST3) configured to supply an initialization voltage (Vref) of an initialization voltage line to the first electrode of the storage capacitor (Cst) in response to an emission control signal (EM0) of a third gate line (20);
a fourth switching transistor (ST4) configured to supply the initialization voltage (Vref) of the initialization voltage line to the anode electrode of the first light-emitting element (EL1; EL11, EL21) in response to the second scan signal (SCAN2) of the second gate line (14); and
a fifth switching transistor (ST5) configured to supply the initialization voltage (Vref) of the initialization voltage line to the anode electrode of the second light-emitting element (EL2; EL12, EL22) in response to the second scan signal (SCAN2) of the second gate line (14).

8. The display panel (100) of claim 2, or any of claims 3 to 7 referring back to claim 2, wherein the first type subpixel (SP11) is one of a plurality of first type subpixels (RPA1, GPA1, BPA1) disposed in the first area (DA1), wherein the plurality of first type subpixels (RPA1, GPA1, BPA1) include a (1-1)th colored subpixel (RPA1), a (1-2)th colored subpixel (GPA1) and a (1-3)th colored subpixel (BPA1),
a size of the (1-1)th lens area (LZ1) disposed on the (1-1)th light emission area (RE11, GE11, BE11) of at least one subpixel of the (1-1)th colored subpixel (RPA1), the (1-2)th colored subpixel (GPA1) or the (1-3)th colored subpixel (BPA1) is different from a size of the (1-1)th lens area (LZ1) of another subpixel of the plurality of first type subpixels (RPA1, GPA1, BPA1), and
the number of the (1-2)th light emission areas (RE12, GE12, BE12) of at least one subpixel of the (1-1)th colored subpixel (RPA1), the (1-2)th colored subpixel (GPA1) or the (1-3)th colored subpixel (BPA1) is different from the number of the (1-2)th light emission areas (RE12, GE12, BE12) of another subpixel of the plurality of first type subpixels (RPA1, GPA1, BPA1).

9. The display panel (100) of claim 3, or any of claims 4 to 8 referring back to claim 3, wherein the second type subpixel (SP21) is one of a plurality of second type subpixels (RPA2, GPA2, BPA2) disposed in the second area (DA2), wherein the plurality of second type subpixels (SP21) include a (2-1)th colored subpixel (RPA2), a (2-2)th colored subpixel (GPA2) and a (2-3)th colored subpixel (BPA2),
a size of the first lens area (LZ1) disposed on the (2-1)th light emission area (RE21) of at least one subpixel of the (2-1)th colored subpixel (RPA2), the (2-2)th colored subpixel (GPA2) or the (2-3)th colored subpixel (BPA2) is different from a size of the first lens area (LZ1) of another subpixel of the plurality of second type subpixels (RPA2, GPA2, BPA2), and
the number of the second lens areas (LZ2) disposed on the (2-2)th light emission area (RE22) of at least one subpixel of the (2-1)th colored subpixel (RPA2), the (2-2)th colored subpixel (GPA2) or the (2-3)th colored subpixel (BPA2) is different from the number of the second lens areas (LZ2) of another subpixel of the plurality of second type subpixels (RPA2, GPA2, BPA2).

10. A display apparatus comprising:
the display panel (100) of any of claims 1 to 9; and
a gate driver (200) disposed in a bezel area (BZ1) outside the display area (DA) in the display panel (100) to drive gate lines (12, 14, 16, 20) connected to the first type subpixel (SP11) and the second type subpixel (SP21),
wherein the gate driver (200) includes an emission control driver (220) configured to control the first and second emission control transistors (ET1, ET2) of the display panel (100).

11. The display apparatus of claim 10 referring back to claim 7, wherein the gate driver (200) further includes a scan driver (210) configured to output the first and second scan signals (SCAN1, SCAN2) to the first and second gate lines (12, 14).
